# EUROPEAN PATENT APPLICATION

(11) **EP 4 266 376 A1**
(43) Date of publication of application: **25.10.2023**
(21) Application number: 21910766.1
(22) Date of filing: 21.12.2021
(51) Int. Cl.: H01L 31/0224, H01L 31/0749

(54) **ELECTRODE STRUCTURE FOR SOLAR CELL AND MANUFACTURING METHOD THEREFOR**

(30) Priority: 21.12.2020 JP 2020211733
(71) Applicant: Idemitsu Kosan Co., Ltd, Tokyo 100-8321 (JP)
(72) Inventor: MIYAGAWA Yoshihide, Tokyo 100-8321 (JP); FUKASAWA Kazuhito, Tokyo 100-8321 (JP); HAMANO Mikio, Tokyo 100-8321 (JP); HORIGUCHI Kyohei, Tokyo 100-8321 (JP); YAMAGUCHI Koji, Tokyo 100-8321 (JP)
(74) Representative: Hoffmann Eitle
(86) International application number: PCT/JP2021/047252
(87) International publication number: WO 2022/138623

(57) **Abstract**

An electrode structure of a solar cell includes an electric conductor on a substrate side of a chalcogen solar cell, and a wiring element to be electrically connected with the electric conductor. The wiring element is stacked on and bonded with the electric conductor. The wiring element and the electric conductor each contain a group VI element. In a stacked direction of the electric conductor and the wiring element, a peak of a concentration distribution of the group VI element is shifted from an interface between the electric conductor and the wiring element.

## Description

### Technical Field

The present invention relates to an electrode structure of a solar cell including a chalcogen solar cell.

### Background Art

CIS-based solar cells using group I-III-VI₂ compound semiconductors each having a chalcopyrite structure containing Cu, In, Ga, Se, and S as a photoelectric conversion layer has conventionally been proposed. The CIS-based solar cells are relatively low in manufacturing cost, and have a large absorption coefficient in a range from a visible wavelength to a near-infrared wavelength. Therefore, high photoelectric conversion efficiency is expected. In addition, the CIS-based solar cells for use in outer space applications are also studied as solar cells, which are excellent in radiation resistance, which have longer lives than those of Si-based solar cells, and which are lower in price than GaAs-based solar cells.

The CIS-based solar cells are each configured by, for example, forming a backside electrode layer of a metal on a substrate, forming a photoelectric conversion layer that is a group I-III-VI₂ compound thereon, and further sequentially forming a buffer layer and a window layer formed of a transparent conductive film. Regarding wiring on a backside electrode on the positive electrode side of the CIS-based solar cell, a method of using soldering as described in Patent Literature 1, an adhesion method of using a conductive paste as described in Patent Literature 2, and the like have conventionally been used.

For example, Patent Literature 1 discloses a connection method for firmly fixing an electrode film or a conductive film by use of a copper foil ribbon conductive wire coated with In-solder, with no damage.

In addition, in the configuration of Patent Literature 2, a ribbon wire adhered with the conductive paste intermittently applied on an electrode is sandwiched between a solar cell submodule and a cover glass that are adhered and held through a filler. Accordingly, the ribbon wire is attached in surface contact with the electrode of the solar cell module.

Further, as a method for bonding a backside electrode layer and a metal ribbon in a solar cell for use on the ground, for example, ultrasonic seam welding as described in Patent Literature 3 is known.

In addition, Patent Literature 4 discloses a technique for enhancing the bonding strength between a connection electrode and an electrode layer in a GaAs-based solar cell. The configuration in Patent Literature 4 includes a GaAs semiconductor layer including a contact region selectively set on a surface, a TiN layer formed on a part of the contact region, and an electrode layer formed on the entire surface of the TiN layer and the contact region. Then, the connection electrode and the electrode layer are welded on a partial or entire surface of the region located on the TiN layer on a surface of the electrode layer.

### Citation List

### Patent Literature

Patent Literature 1: JP 2007-207861 A
Patent Literature 2: JP 2009-252975 A
Patent Literature 3: JP 2000-4034 A
Patent Literature 4: JP S62-55963 A

### Summary of Invention

### Technical Problem

In the solar cells for outer space applications, there is a demand for a bonding technique of an interconnector with higher adhesion than that for use on the ground so as to be capable of withstanding a rapid temperature change in outer space environments and an impact at the time of launching. Further, the solar cells for outer space applications are exposed to temperatures equal to or higher than the melting point of solder, depending on the altitude or solar radiation. Furthermore, commonly used adhesives for adhering electrodes and the like are poor in UV resistance.

For this reason, when the interconnector is bonded by soldering or adhering that is common in the solar cells for use on the ground, there is a concern that adhesive force decreases under operation of the solar cells, thereby leading to an electrical connection failure. From such a viewpoint, parallel-gap resistance welding is recommended for bonding the interconnector in the solar cells for outer space applications.

On a surface of the backside electrode layer (Mo) of the CIS-based solar cell, by the way, a Mo(Se,S)₂ layer having a layered structure and low adhesive strength is present. Therefore, in bonding the interconnector of the CIS-based solar cell, even though a Ti-based bonding layer is formed on the backside electrode layer as described in Patent Literature 4, it is difficult to sufficiently enhance the adhesive strength between the bonding layer and the backside electrode layer because of the presence of the Mo(Se,S)₂ layer.

In addition, the phenomenon of this type may occur in a similar manner, for example, also in a case where a wiring element is welded to a conductive substrate of the CIS-based solar cell, and a Mo(Se,S)₂ layer or a Ti(Se,S)₂ layer is present on a substrate surface.

The present invention has been made in view of the above circumstances, and provides an electrode structure in which adhesive strength between an electric conductor on a substrate side of a chalcogen solar cell and a wiring element is enhanced, in a solar cell including a chalcogen solar cell.

### Solution to Problem

One aspect of the present invention is an electrode structure of a solar cell includes an electric conductor on a substrate side of a chalcogen solar cell, and a wiring element to be electrically connected with the electric conductor. The wiring element is stacked on and bonded with the electric conductor. The wiring element and the electric conductor each contain a group VI element. In a stacked direction of the electric conductor and the wiring element, a peak of a concentration distribution of the group VI element is shifted from an interface between the electric conductor and the wiring element.

### Advantageous Effects of Invention

According to the present invention, in a solar cell including a chalcogen solar cell, the adhesive strength between an electric conductor on a substrate side of the chalcogen solar cell and a wiring element can be enhanced.

### Brief Description of Drawings

Fig. 1(a) is a plan view illustrating a configuration example of a solar cell in a first embodiment, and Fig. 1(b) is an enlarged view around a connection portion surrounded by a broken line in Fig. 1(a).
Fig. 2 is a cross-sectional view in a thickness direction of Fig. 1(b).
Fig. 3 is a flowchart illustrating a manufacturing method of a solar cell.
Fig. 4 is a diagram schematically illustrating steps of the manufacturing method of Fig. 3.
Fig. 5 is a diagram subsequent to Fig. 4.
Fig. 6 is a cross-sectional view in the thickness direction illustrating a configuration example of a solar cell in a second embodiment.
Fig. 7 is a cross-sectional view in the thickness direction illustrating a configuration example of a solar cell in a third embodiment.
Fig. 8 is a cross-sectional view in the thickness direction illustrating a configuration example of a solar cell in a fourth embodiment.
Fig. 9 is a cross-sectional view in the thickness direction illustrating a configuration example of a solar cell in a fifth embodiment.
Fig. 10 is a diagram illustrating an example of a concentration distribution of respective elements in the thickness direction of a connection portion in Examples.
Fig. 11 is a diagram illustrating an example of a concentration distribution of the respective elements in the thickness direction of the connection portion in Examples.
Fig. 12 is a table indicating results of adhesive strength tests of Example 1 and Comparative Examples.
Fig. 13 is a table indicating presence or absence of an alloy phase in a phase diagram of Example 1 and Comparative Examples.
Fig. 14 is a table indicating results of adhesive strength tests of Examples 2 to 7.
Fig. 15 is a table indicating presence or absence of an alloy phase in a phase diagram of Examples 2 to 7.

### Description of Embodiments

Hereinafter, embodiments will be described with reference to the drawings.

In the embodiments, in order to facilitate understanding, structures and elements other than the main components of the present invention will be described in a simplified or omitted manner. In addition, in the drawings, the same elements are denoted by the same reference numerals. Note that in the drawings, shapes, dimensions, and the like of each element are schematically illustrated, and do not indicate actual shapes, dimensions, or the like.

### <<Description of First Embodiment>>

### <Structure of Solar Cell>

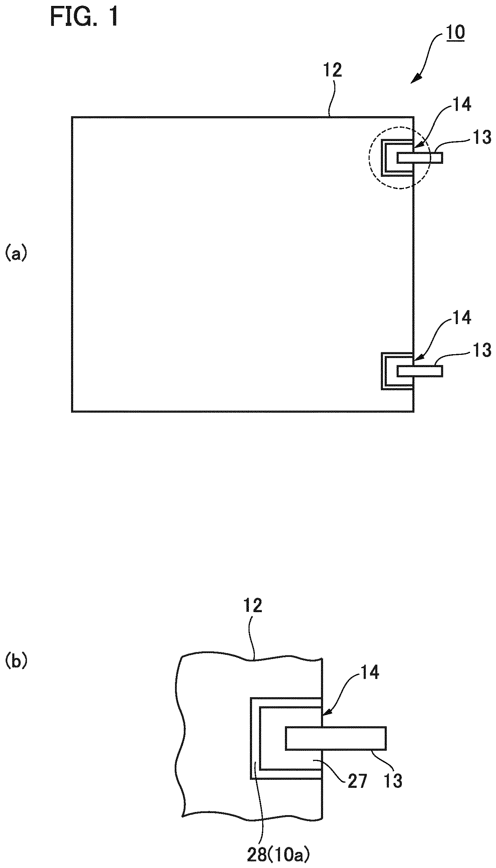

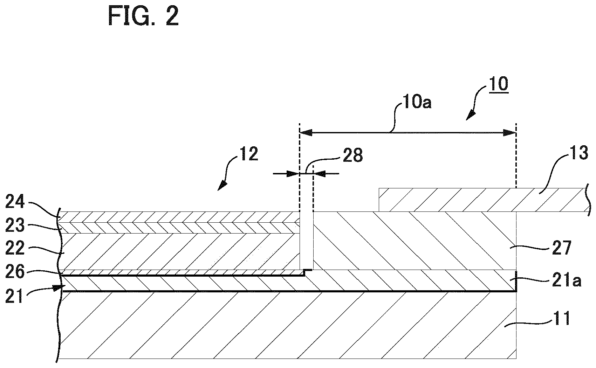

Fig. 1(a) is a plan view illustrating a configuration example of a solar cell in a first embodiment. Fig. 1(b) is an enlarged view around a connection portion surrounded by a broken line in Fig. 1(a). Fig. 2 is a cross-sectional view in a thickness direction of Fig. 1(b). In the first embodiment, a configuration example of a CIS-based solar cell module 10 will be described as an example of a solar cell including a chalcogen solar cell.

The solar cell module 10 illustrated in Figs. 1 and 2 includes a conductive substrate 11, on which a photoelectric conversion element 12 is formed on a light-receiving surface side, an interconnector 13, and a connection portion 14 for electrically connecting the photoelectric conversion element 12 and the interconnector 13.

### (Conductive Substrate 11)

The conductive substrate 11 is formed of, for example, titanium (Ti), stainless steel (SUS), copper, aluminum, an alloy thereof, or the like. The conductive substrate 11 may be a flexible substrate. The conductive substrate 11 may have a stacked structure in which a plurality of metal base materials are stacked. For example, stainless foil, titanium foil, or molybdenum foil may be formed on a surface of the substrate.

The shape and dimensions of the conductive substrate 11 are appropriately determined in accordance with the size or the like of the solar cell module 10. The entire shape of the conductive substrate 11 in the first embodiment is, for example, a rectangular flat plate shape, but is not limited to this.

In a case where a metal substrate or a flexible substrate is applied as the conductive substrate 11, the solar cell module 10 becomes bendable, and cracking of the substrate due to bending can also be suppressed. Furthermore, in the above case, it becomes easy to reduce the weight and thickness of the solar cell module 10, as compared with a glass substrate or a resin substrate.

Note that regarding the solar cells for outer space applications, the conductive substrate 11 is desirably formed of titanium or an alloy containing titanium from the viewpoint of suppressing the load weight at the time of launching and enhancing the strength of the solar cells.

### (Photoelectric Conversion Element 12)

The photoelectric conversion element 12 is an example of a chalcogen solar cell, and has a stacked structure in which a first electrode layer 21, a photoelectric conversion layer 22, a buffer layer 23, and a second electrode layer 24 are sequentially stacked on the conductive substrate 11. Light such as sunlight enters the photoelectric conversion element 12 from an opposite side (upper side of Fig. 2) to the conductive substrate 11 side.

### (First Electrode Layer 21)

The first electrode layer 21 is, for example, a metal electrode layer of molybdenum (Mo), and is formed on the conductive substrate 11. The first electrode layer 21 faces a back surface side (substrate side) of the photoelectric conversion layer 22 that is not a light-receiving surface side, and thus will also be referred to as a backside electrode. Although not particularly limited, the thickness of the first electrode layer 21 is, for example, 200 nm to 1000 nm.

In addition, in the first electrode layer 21 in the photoelectric conversion element 12, a group VI compound layer 26 made of Mo(Se,S)₂ is formed in an interface with the photoelectric conversion layer 22. Mo(Se,S)₂ of the group VI compound layer 26 is formed in the first electrode layer 21, when a precursor layer 22p to be described later is chalcogenized to form the photoelectric conversion layer 22. Note that Mo(Se,S)₂ of the group VI compound layer 26 is a substance having a graphite-like multilayer structure, and has a property of being easily peeled off by cleavage between layers.

Here, in the solar cell module 10 in the first embodiment, the photoelectric conversion element 12 is stacked on the conductive substrate 11, and thus the photoelectric conversion layer 22 can be directly stacked on the conductive substrate 11 without the first electrode layer 21. In a case where the photoelectric conversion layer 22 is directly stacked on the conductive substrate 11, a group VI compound layer is formed in an interface between the conductive substrate 11 and the photoelectric conversion layer 22, when the precursor layer 22p to be described later is chalcogenized. For example, in a case where the conductive substrate 11 is Ti, a group VI compound layer made of Ti(Se,S)₂ is formed in the interface between the conductive substrate 11 and the photoelectric conversion layer 22. Note that similarly to Mo(Se,S)₂, Ti(Se,S)₂ is also a substance having the graphite-like multilayer structure, and has a property of being easily peeled off by the cleavage between layers.

### (Photoelectric Conversion Layer 22)

The photoelectric conversion layer 22 is formed on the first electrode layer 21. The photoelectric conversion layer 22 may have a double graded structure in which a band gap is large on each the light-receiving surface side (upper side of Fig. 2) and a conductive substrate 11 side (lower side of Fig. 2) and the band gap is small on an inner side in the thickness direction of the photoelectric conversion layer 22. Although not particularly limited, the thickness of the photoelectric conversion layer 22 is, for example, 1.0 um to 3.0 um.

The photoelectric conversion layer 22 functions as a polycrystalline or microcrystalline p-type compound semiconductor layer. The photoelectric conversion layer 22 is a CIS-based photoelectric conversion element using a group I-III-VI₂ compound semiconductor having a chalcopyrite structure containing a group I element, a group III element, and a group VI element (chalcogen element). The group I element is selectable from copper (Cu), silver (Ag), gold (Au), and the like. The group III element is selectable from indium (In), gallium (Ga), aluminum (Al), and the like. In addition, the photoelectric conversion layer 22 may contain tellurium (Te) or the like, in addition to selenium (Se) and sulfur (S) as the group VI elements. Further, the photoelectric conversion layer 22 may contain an alkali metal such as Li, Na, K, Rb, or Cs.

Note that the photoelectric conversion layer 22 as a chalcogen solar cell may be a CZTS-based photoelectric conversion element using a chalcogenide-based group I₂-(II-IV)-VI₄ compound semiconductor containing Cu, Zn, Sn, S, or Se. As typical examples of the CZTS-based photoelectric conversion element, a CZTS-based photoelectric conversion element using a compound such as Cu₂ZnSnSe₄ or Cu₂ZnSn(S,Se)₄ can be mentioned.

### (Buffer Layer 23)

The buffer layer 23 is formed on the photoelectric conversion layer 22. Although not particularly limited, the thickness of the buffer layer 23 is, for example, 10 nm to 100 nm.

The buffer layer 23 is, for example, an n-type or an i(intrinsic)-type high-resistance conductive layer. Here, the term "high resistance" means having a resistance value higher than the resistance value of the second electrode layer 24 to be described later.

The buffer layer 23 is selectable from compounds containing zinc (Zn), cadmium (Cd), and indium (In). Examples of the compounds containing zinc include ZnO, ZnS, and Zn(OH)₂, or Zn(O,S) and Zn(O,S,OH) which are their mixed crystals, and further include ZnMgO and ZnSnO. Examples of the compound containing cadmium include CdS and CdO, or Cd(O,S) and Cd(O,S,OH) which are their mixed crystals. Examples of the compound containing indium include InS and InO, or In(O,S) and In(O,S,OH) which are their mixed crystals, and In₂O₃, In₂S₃, In(OH)ₓ, or the like can be used. In addition, the buffer layer 23 may have a stacked structure of these compounds.

Note that the buffer layer 23 has an effect of improving characteristics such as photoelectric conversion efficiency, but can be omitted. In a case where the buffer layer 23 is omitted, the second electrode layer 24 is formed on the photoelectric conversion layer 22.

### (Second Electrode Layer 24)

The second electrode layer 24 is formed on the buffer layer 23. The second electrode layer 24 is, for example, an n-type conductive layer. Although not particularly limited, the thickness of the second electrode layer 24 is, for example, 0.5 um to 2.5 um.

The second electrode layer 24 desirably includes, for example, a material having a wide forbidden band width and a sufficiently low resistance value. In addition, the second electrode layer 24 serves as a passage for light such as sunlight, and thus the second electrode layer 24 desirably has a property of transmitting light having a wavelength that can be absorbed by the photoelectric conversion layer 22. From this point of view, the second electrode layer 24 will also be referred to as a transparent electrode layer or a window layer.

The second electrode layer 24 includes, for example, a metal oxide to which a group III element (B, Al, Ga, or In) is added as a dopant. Examples of the metal oxide include ZnO and SnO₂. The second electrode layer 24 is selectable from, for example, indium tin oxide (ITO), indium titanium oxide (ITiO), indium zinc oxide (IZO), zinc tin oxide (ZTO), fluorine-doped tin oxide (FTO), gallium-doped zinc oxide (GZO), boron-doped zinc oxide (BZO), and the like.

### (Interconnector 13)

The interconnector 13 is a wiring member on the positive electrode side of the solar cell module 10, and two interconnectors are connected in parallel with each other respectively in end parts on a right side of the solar cell module 10 in Fig. 1. The interconnector 13 is, for example, a ribbon wire of an electrically conductive metal containing Ag as a material.

Although not particularly limited, regarding the dimensions of the interconnector, a strip shape with a thickness of approximately 30 um and a width of approximately 2.5 mm can be formed.

Here, the material of the interconnector 13 is not limited to the electrically conductive metal containing Ag. For example, an iron(Fe)-nickel(Ni)-cobalt(Co) alloy (for example, Kovar (registered trademark) or the like) or Ti may be used.

In a case where the iron-nickel-cobalt alloy is used as the material of the interconnector 13, the ratios of Fe, Ni, and Co may be similar to those in Kovar (Fe: 53.5%, Ni: 29%, Co: 170) or may be any other ratios.

For example, in reducing the difference in thermal expansion coefficient between the interconnector 13 and the conductive substrate 11, the stress acting on the connection portion 14 due to thermal expansion is reduced, and thus it becomes easy to suppress a decrease in adhesive strength of the connection portion 14. For this reason, the ratios of Fe, Ni, and Co in the iron-nickel-cobalt alloy may be adjusted to reduce the difference in thermal expansion coefficient from the conductive substrate 11.

In addition, Fe contained in the iron-nickel-cobalt alloy may be increased in order to promote diffusion of metals between the elements that face each other.

Note that in the first embodiment, the description of the wiring on the negative electrode side of the solar cell module 10 is omitted.

### (Connection Portion 14)

The connection portion 14 is an element for connecting the interconnector 13 and the first electrode layer 21 of the photoelectric conversion element 12, and the connection portions 14 are respectively provided in two places in end parts on the right side of the solar cell module 10 of Fig. 1. Each connection portion 14 is formed in a wiring region 10a, in which the photoelectric conversion element 12 is partially cut out to expose the first electrode layer 21 on the light-receiving surface side. Although not particularly limited, regarding the dimensions of the wiring region 10a in a planar direction, for example, a rectangular shape has approximately 5 mm × 5 mm.

As illustrated in Fig. 2, the connection portion 14 has a stacked structure in which a first electrode layer 21a corresponding to the wiring region 10a and a bonding layer 27 are sequentially stacked on the conductive substrate 11. In addition, an end portion of the interconnector 13 is attached to the upper surface of the bonding layer 27 by welding. The bonding layer 27 and the interconnector 13 are welded by parallel-gap resistance welding, for example.

The first electrode layer 21a corresponding to the wiring region 10a is formed integrally with the first electrode layer 21 of the photoelectric conversion element 12.

However, in the first electrode layer 21, which faces the photoelectric conversion layer 22 of the photoelectric conversion element 12, the group VI compound layer 26 is formed in the interface with the photoelectric conversion layer 22. On the other hand, the group VI compound layer 26 is not formed in the first electrode layer 21a of the wiring region 10a. In the wiring region 10a, the group VI compound layer 26, which is easily peeled off, is not formed between the first electrode layer 21a and the bonding layer 27. Therefore, the bonding layer 27 is hardly peeled off from the first electrode layer 21a.

In addition, in the first electrode layer 21a of the wiring region 10a, a metal element (for example, Al) of the bonding layer 27, Se and S that are the group VI elements, and the like are diffused, as will be described later. The metal element of the bonding layer 27 diffuses into the first electrode layer 21a, and thus the first electrode layer 21a and the bonding layer 27 have high adhesive strength.

On the other hand, the first electrode layer 21 in the photoelectric conversion element 12 is not in contact with the bonding layer 27. For this reason, there is almost no diffusion of the metal element into the bonding layer 27 in the first electrode layer 21 in the photoelectric conversion element 12, unlike the first electrode layer 21a in the wiring region 10a.

### (Bonding Layer 27)

The bonding layer 27 is a conductive layer for electrically connecting the first electrode layer 21a of the wiring region 10a and the interconnector 13, and is made up of a substance containing a group VI element that has diffused into a conductive metal material. As an example, the bonding layer 27 in the first embodiment is a substance containing Al and Ag, and containing Se and S that have been diffused.

As illustrated in Figs. 1 and 2, a groove 28 is formed between the photoelectric conversion layer 22, the buffer layer 23, and the second electrode layer 24 around the bonding layer 27 in the planar direction of a light-receiving surface. Therefore, the bonding layer 27 is insulated by the groove 28 from the photoelectric conversion layer 22, the buffer layer 23, and the second electrode layer 24. Although not particularly limited, the thickness of the bonding layer 27 is approximately 2.0 um to 3.0 µm.

As the metal material of the bonding layer 27, a metal material having a melting point equal to or higher than 230°C and higher than that of the solder alloy is used in order to ensure the use of the solar cell module 10 at high temperatures due to solar radiation or the like in outer space environments. Note that both Al and Ag described above have melting points equal to or higher than 230°C.

In addition, the material of the bonding layer 27 desirably contains at least one of Al, Pt, Zn, and Sn, which are metal elements to be easily chalcogenized. Since the bonding layer 27 contains a metal element to be easily chalcogenized, the group VI compound is likely to be distributed uniformly in the bonding layer 27. Then, when the bonding layer 27 to be described later is formed, the diffusion of the group VI element from the group VI compound layer 26 into the bonding layer 27 is promoted. By such diffusion of the group VI element, the group VI compound layer 26 can be made to disappear from between the first electrode layer 21a and the bonding layer 27.

As described above, when the bonding layer 27 is formed, the group VI element diffuses into the bonding layer 27, and the group VI compound layer 26 disappears. For this reason, in the concentration distribution of the group VI element in the thickness direction of the connection portion 14, there is no peak in the concentration of the group VI element in the interface between the first electrode layer 21a and the bonding layer 27.

In addition, the material of the bonding layer 27 contains a metal element to be easily chalcogenized, and thus the group VI element diffuses more into the bonding layer 27 side in the thickness direction of the connection portion 14. Therefore, in the concentration distribution of the group VI element in the thickness direction of the connection portion 14, a peak in the concentration of the group VI element is generated in the bonding layer 27. In other words, the number of atoms of the group VI element contained in the bonding layer 27 is larger than the number of atoms of the group VI element contained in the first electrode layer 21a.

In addition, the material of the bonding layer 27 desirably contains a metal element having an alloy phase in a phase diagram with respect to the material of the first electrode layer 21a, which is a backside electrode layer. Alternatively, the material of the bonding layer 27 may include at least one of the constituent elements of the first electrode layer 21a.

In selecting the material of the bonding layer 27, it is sufficient if a metal having an alloy phase in a phase diagram with respect to the material (Mo) of the first electrode layer 21a is selected from a binary phase diagram (for example, BINARY ALLOY PHASE DIAGRAMS SECOND EDITION Vol. 1, T.B. Massalski, 1990).

The bonding layer 27 includes a metal element (for example, Al or the like) having an alloy phase in a phase diagram with respect to the material of the first electrode layer 21a or at least one of constituent elements of the first electrode layer 21a, and thus the metal element easily diffuses between the first electrode layer 21a and the bonding layer 27. Further, as described above, in accordance with the group VI element diffusing more into the bonding layer 27 side, the metal element contained in the bonding layer 27 becomes in a state of easily diffusing into the first electrode layer 21a. Accordingly, the adhesive strength between the first electrode layer 21a and the bonding layer 27 can be improved.

In addition, Ag contained in the bonding layer 27 is also contained in the interconnector 13 as described above. That is, the interface between the bonding layer 27 and the interconnector 13 has high affinity, because both materials contain Ag. Therefore, when the interconnector 13 is welded, the metal elements also diffuse in the interface between the interconnector 13 and the bonding layer 27, and the adhesive strength between the interconnector 13 and the bonding layer 27 is improved.

### <Method for Manufacturing Solar Cell>

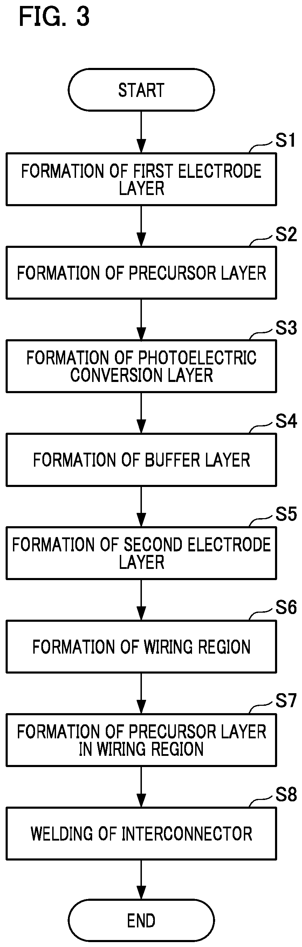

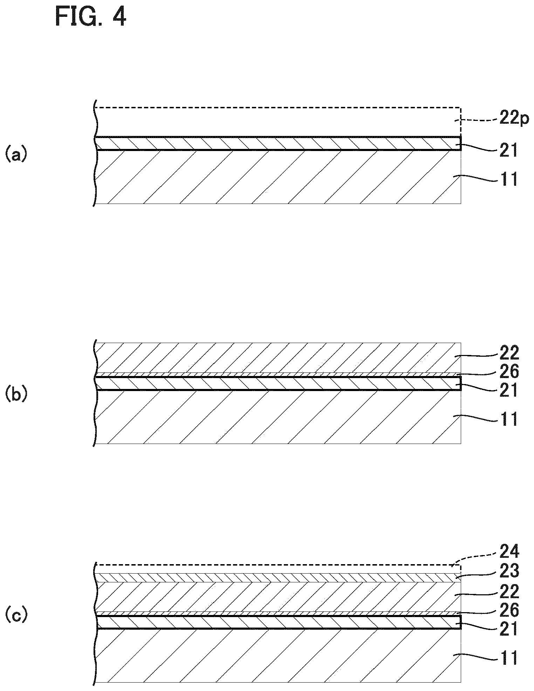

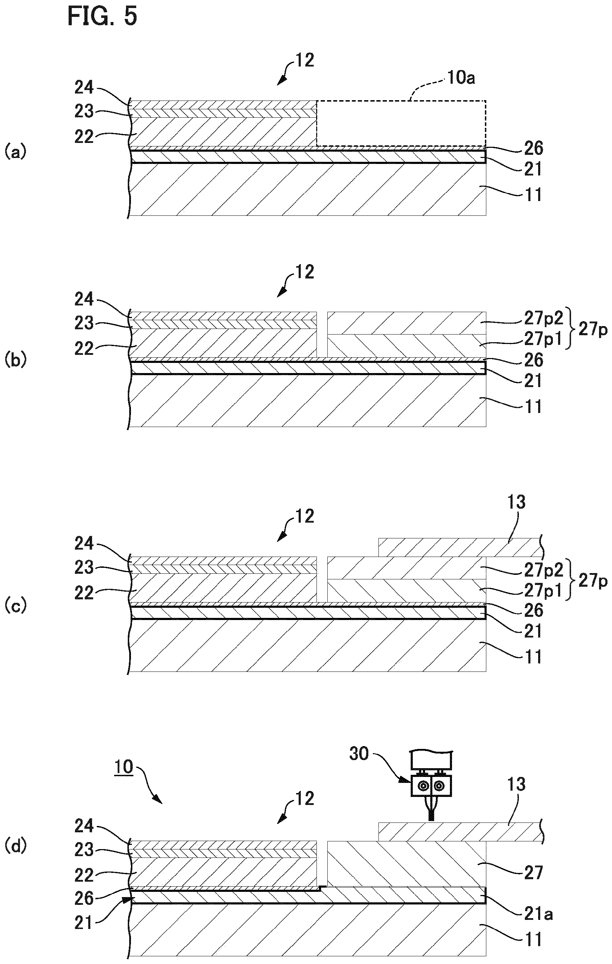

Next, an example of a manufacturing method of the solar cell module 10 will be described. Fig. 3 is a flowchart illustrating a manufacturing method of the solar cell module 10. Figs. 4 and 5 are diagrams schematically illustrating the respective steps in the manufacturing method.

### (S1: Formation of First Electrode Layer)

In S1, as illustrated in Fig. 4(a), the first electrode layer 21 is formed by making a thin film of molybdenum (Mo) or the like on a surface of the conductive substrate 11 of titanium or the like by a sputtering method, for example. The sputtering method may be a direct-current (DC) sputtering method or a radio frequency (RF) sputtering method. In addition, the first electrode layer 21 may be formed by use of a chemical vapor deposition (CVD) method, an atomic layer deposition (ALD) method, or the like, instead of the sputtering method.

### (S2: Formation of Precursor Layer)

In S2, a precursor layer 22p in a thin film shape is formed on the first electrode layer 21, as indicated by a broken line in Fig. 4(a).

As a method for forming the precursor layer 22p on the first electrode layer 21, for example, the above sputtering method, a vapor deposition method, and an ink coating method can be mentioned. The vapor deposition method is a method for making a film by heating a vapor deposition source and then using atoms or the like that have become a vapor phase. The ink coating method is a method for dispersing the powdered material of the precursor film in a solvent such as an organic solvent, applying the solvent onto the first electrode layer 21, and then evaporating the solvent to form the precursor layer 22p.

When the CIS-based photoelectric conversion layer 22 is formed, the precursor layer 22p contains a group I element and a group III element. For example, the precursor layer 22p may contain Ag as the group I element. The group I element other than Ag to be contained in the precursor layer 22p is selectable from copper, gold, and the like. In addition, the group III element to be contained in the precursor layer 22p is selectable from indium, gallium, aluminum, and the like. Further, the precursor layer 22p may contain an alkali metal such as Li, Na, K, Rb, or Cs. Further, the precursor layer 22p may contain tellurium as a group VI element, in addition to selenium and sulfur.

On the other hand, when the CZTS-based photoelectric conversion layer 22 is formed, the precursor layer 22p is made as a thin film of Cu-Zn-Sn or Cu-Zn-Sn-Se-S.

### (S3: Formation of Photoelectric Conversion Layer)

In S3, as illustrated in Fig. 4(b), the precursor layer 22p is chalcogenized to form the photoelectric conversion layer 22.

In a case where the CIS-based photoelectric conversion layer 22 is formed, in a chalcogenized treatment of the precursor layer 22p, the precursor layer 22p containing a group I element and a group III element is subject to a thermal treatment in an atmosphere containing a group VI element to be chalcogenized, and the photoelectric conversion layer 22 is formed.

For example, first, selenization in a vapor phase selenization method is performed. The selenization is performed by heating the precursor layer in an atmosphere of a selenium source gas (for example, hydrogen selenide or selenium vapor) containing selenium as a group VI element source. Although not particularly limited, the selenization is, for example, desirably performed at a temperature within a range equal to or higher than 300°C and equal to or lower than 600°C in a heating furnace.

As a result, the precursor layer is converted into a compound containing a group I element, a group III element, and selenium (photoelectric conversion layer 22). Note that the compound containing the group I element, the group III element, and selenium (photoelectric conversion layer 22) may be formed by any other method than the vapor phase selenization method. For example, such a compound can also be formed in a solid-phase selenization method, a vapor deposition method, an ink application method, an electrodeposition method, or the like.

Next, the photoelectric conversion layer 22 containing the group I element, the group III element, and selenium is sulfurized. Sulfurization is performed by heating the photoelectric conversion layer 22 in an atmosphere of a sulfur source gas that contains sulfur (for example, hydrogen sulfide or sulfur vapor). As a result, the photoelectric conversion layer 22 is converted into a compound containing a group I element, a group III element, and selenium and sulfur as group VI elements. In a surface part of the photoelectric conversion layer 22, the sulfur source gas serves as substituting selenium in a crystal containing a group I element, a group III element, and selenium, such as for example selenium in a chalcopyrite crystal with sulfur.

Although not particularly limited, the sulfurization is, for example, desirably performed at a temperature within a range equal to or higher than 450°C and equal to or lower than 650°C in a heating furnace.

On the other hand, in a case where the CZTS-based photoelectric conversion layer 22 is formed, in the chalcogenized treatment of the precursor layer 22p, the precursor layer 22p containing Cu, Zn, and Sn is sulfurized and selenized in a hydrogen sulfide atmosphere and a hydrogen selenide atmosphere at 500°C to 650°C. Accordingly, the CZTS-based photoelectric conversion layer 22 containing Cu₂ZnSn(S,Se)₄ can be formed.

In addition, in accordance with the chalcogenized treatment of the precursor layer 22p in S3, the group VI compound layer 26 containing Mo(Se,S)₂ is formed in the interface in the first electrode layer 21 between the first electrode layer 21 and the photoelectric conversion layer 22.

### (S4: Formation of Buffer Layer)

In S4, as illustrated in Fig. 4(c), a thin film of, for example, Zn(O,S) or the like is made on the photoelectric conversion layer 22 in a method such as a chemical bath deposition (CBD) method or a sputtering method, and the buffer layer 23 is formed. Note that the formation of the buffer layer 23 may be omitted.

### (S5: Formation of Second Electrode Layer)

In S5, as indicated by a broken line in Fig. 4(c), the second electrode layer 24 is formed on the buffer layer 23 in a method such as a sputtering method, a CVD method, or an ALD method. The second electrode layer 24 is, for example, a transparent electrode made up of a thin film such as ZnO doped with B, Al, or In as a dopant.

In the above steps S1 to S5, the photoelectric conversion element 12 is formed on the conductive substrate 11.

### (S6: Formation of Wiring Region)

In S6, a predetermined position in an end part of the light-receiving surface of the photoelectric conversion element 12 is partially cut out by, for example, mechanical patterning, and the wiring region 10a in which the first electrode layer 21 is exposed is formed on the light-receiving surface side. Note that in step S6, the group VI compound layer 26 is present on a surface of the first electrode layer 21 in the wiring region 10a, in a similar manner to the first electrode layer 21 in the photoelectric conversion element 12.

As an example, Fig. 5(a) illustrates a state in which the photoelectric conversion layer 22, the buffer layer 23, and the second electrode layer 24 corresponding to the wiring region 10a of the photoelectric conversion element 12 are removed. Note that in Fig. 5(a), the region removed in S6 is indicated by a broken line.

### (S7: Formation of Precursor Layer in Wiring Region)

In S7, as illustrated in Fig. 5(b), a precursor layer 27p corresponding to the bonding layer 27 is formed on the first electrode layer 21 in the wiring region 10a.

In S7, first, on the light-receiving surface of the photoelectric conversion element 12, a region other than the region where the precursor layer 27p is to be formed (inside of the groove 28 in the wiring region 10a) is appropriately masked. Thereafter, the precursor layer 27p is formed on the first electrode layer 21 in the wiring region 10a in a vapor deposition method, for example.

The precursor layer 27p in S7 is formed by sequentially stacking an Al layer 27p1 and an Ag layer 27p2 in this order from a conductive substrate 11 side. The film-making conditions for the Al layer 27p1 are, for example, an applied voltage of approximately 10 kV, an EB current of approximately 0.2 A, a film-making rate of 0.4 nm/sec, and a thickness of 0.5 um. Similarly, the film-making conditions for the Ag layer 27p2 are, for example, an applied voltage of approximately 10 kV, an EB current of approximately 0.1 A, a film-making rate of 0.5 nm/sec, and a thickness of 2.0 µm.

In the precursor layer 27p, the Ag layer 27p2 is disposed on an upper surface side facing the interconnector 13. By disposing the Ag layer 27p2 common to a material of the interconnector 13 in a region facing the interconnector 13, diffusion easily occurs in the interface between the interconnector 13 and the precursor layer 27p at the time of welding.

In addition, in the precursor layer 27p, the Al layer 27p1 is disposed on a lower surface side facing the group VI compound layer 26 of the first electrode layer 21. By disposing the Al layer 27p1, which is easily chalcogenized, in a region facing the group VI compound layer 26, the group VI compound easily diffuses into the bonding layer 27 side at the time of welding.

### (S8: Welding of Interconnector)

In S8, an end portion of the interconnector 13 made of an electrically conductive metal containing Ag is disposed on an upper surface of the precursor layer 27p, and the interconnector 13 is welded to the solar cell module 10. As an example, the interconnector 13 is welded in a parallel-gap welding method using a resistance welding machine with a transistor control method.

Specifically, as illustrated in Fig. 5(c), the end portion of the interconnector 13 is disposed in a central part of the upper surface of the precursor layer 27p so as not to protrude outward from a peripheral edge portion of the precursor layer 27p. Then, the interconnector 13 is welded onto the precursor layer 27p by use of, for example, a pair of electrodes 30, which are partitioned by a narrow gap.

Note that the welding conditions in S8 are, for example, a welding current of 50 to 200 A and a welding time of 5 to 900 msec.

While being welded with the interconnector 13, the precursor layer 27p receives thermal energy from the electrodes 30 through the interconnector 13. Then, diffusion occurs in an interface between the interconnector 13 and the precursor layer 27p and an interface between the precursor layer 27p and the first electrode layer 21. Diffusion also occurs between the Al layer 27p1 and the Ag layer 27p2 in the precursor layer 27p. Accordingly, as illustrated in Fig. 5(d), the precursor layer 27p having a stacked structure of the Al layer 27p1 and the Ag layer 27p2 is changed into the bonding layer 27 in which Ag, Al, and Se that is a group VI element are diffused.

When the diffusion occurs in the interface between the precursor layer 27p and the first electrode layer 21 because of the thermal energy at the time of welding, Se in the group VI compound layer 26 in the first electrode layer 21 diffuses into the first electrode layer 21a and the bonding layer 27. Due to such diffusion of Se, the group VI compound layer 26 disappears from between the first electrode layer 21a and the bonding layer 27. Since the group VI compound layer 26, which is easily peeled off, is no longer present between the first electrode layer 21a and the bonding layer 27 after the welding, the first electrode layer 21a and the bonding layer 27 are hardly peeled off.

In addition, the Al layer 27p1, which is easily chalcogenized, is disposed on the first electrode layer 21 side of the precursor layer 27p. Therefore, Se that diffuses from the group VI compound layer 26 diffuses more into the bonding layer 27 side containing Al to be easily chalcogenized than into the first electrode layer 21a side containing Mo. Then, in accordance with Se diffusing more into the bonding layer 27 side, Al of the metal element contained in the precursor layer 27p easily diffuses into the first electrode layer 21a. Al, which is a metal element of the bonding layer 27, diffuses into the first electrode layer 21a, and thus the adhesive strength between the first electrode layer 21a and the bonding layer 27 after the welding is further improved.

On the other hand, the interface between the Ag layer 27p2 of the precursor layer 27p and the interconnector 13 has high affinity, because both materials contain Ag. Therefore, the metal element diffuses into the interface between the interconnector 13 and the precursor layer 27p at the time of welding, and the interconnector 13 and the bonding layer 27 are bonded together with high adhesive strength.

In steps S1 to S8 described above, the connection portion 14, in which the first electrode layer and the interconnector are bonded together through the bonding layer, is formed in the wiring region of the solar cell module 10.

Heretofore, the description with reference to Fig. 3 ends.

As described above, in the first embodiment, in the wiring region 10a, the precursor layer 27p containing Al is formed on the first electrode layer 21, which includes the group VI compound layer 26 (S7). Then, the precursor layer 27p and the interconnector 13 are welded together, thermal energy is applied, and then the bonding layer 27 containing the group VI element and Al of the precursor layer 27p is formed (S8).

Accordingly, in the connection portion 14 between the photoelectric conversion element 12 and the interconnector 13, the group VI element diffuses into the bonding layer 27, and the peak in the concentration distribution of the group VI element is shifted in a stacked direction from the interface between the first electrode layer 21 and the bonding layer 27. That is, in the connection portion 14 in the first embodiment, since the group VI compound layer 26 disappears from the interface between the first electrode layer 21 and the bonding layer 27, the adhesive strength between the first electrode layer 21 and the bonding layer 27 can be enhanced.

### <Second Embodiment>

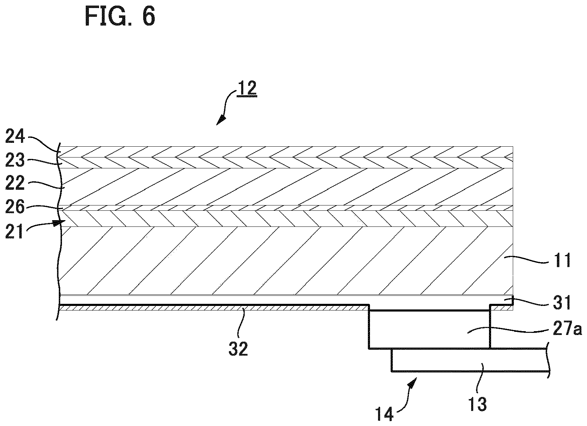

Fig. 6 is a cross-sectional view in a thickness direction illustrating a configuration example of a solar cell in a second embodiment. The second embodiment is a modified example from the first embodiment, and a connection portion 14 is formed on a back surface side (surface on an opposite side to the light-receiving surface) of the conductive substrate 11 of the solar cell module 10.

Note that in the following description of each embodiment, the same reference numerals are given to the same configurations as those of the first embodiment, and overlapping descriptions will be omitted.

As illustrated in Fig. 6, a conductive coating layer 31 of molybdenum (Mo) is formed on the back surface side of the conductive substrate 11 in the second embodiment, and a bonding layer 27a is stacked on the conductive coating layer 31. Then, an end portion of the interconnector 13 is attached to the lower side in the drawing of the bonding layer 27a by welding. The interconnector 13 in the second embodiment is a ribbon wire made of, for example, an electrically conductive metal containing Ag, Ti, an iron-nickel-cobalt alloy, or the like, as a material.

The conductive coating layer 31 is formed on the back surface side of the conductive substrate 11, so that warpage of the solar cell module 10 can be reduced.

In addition, a group VI compound layer 32, which is made of Mo(Se,S)₂, is formed on a surface of the conductive coating layer 31, except for a region where the bonding layer 27a is stacked. Mo(Se,S)₂ of the group VI compound layer 32 is formed in the conductive coating layer 31, when the precursor layer 22p is chalcogenized to form the photoelectric conversion layer 22. Note that the group VI compound layer 32 made of Mo(Se,S)₂ has properties similar to those of the group VI compound layer 26 of the first electrode layer 21.

In other words, the group VI compound layer 32, which is easily peeled off, is not formed between the conductive coating layer 31 and the bonding layer 27a. Therefore, the bonding layer 27a is hardly peeled off from the conductive coating layer 31.

In addition, the bonding layer 27a in the second embodiment is a substance containing at least one of Al, Pt, Zn, and Sn and containing diffused Se and S. As the metal material of the bonding layer 27a, a metal material having a melting point equal to or higher than 230°C and higher than that of the solder alloy is used in order to ensure the use of the solar cell module 10 at high temperatures due to solar radiation or the like in outer space environments. In addition, the material of the bonding layer 27a desirably contains a metal element having an alloy phase in a phase diagram with respect to the material of the conductive coating layer 31 and the material of the interconnector 13 in order to promote diffusion of the metal element between the members.

In addition, the material of the bonding layer 27a desirably contains at least one of Al, Pt, Zn, and Sn, which are metal elements to be easily chalcogenized. Accordingly, the group VI compound is likely to be uniformly distributed in the bonding layer 27a. When the bonding layer 27a is formed, diffusion of the group VI element from the group VI compound layer 32 into the bonding layer 27a side is promoted, so that the group VI compound layer 32 can be made to disappear from between the conductive coating layer 31 and the bonding layer 27a.

In addition, in the conductive coating layer 31, a metal element (for example, Al) of the bonding layer 27a, Se and S that are group VI elements, and the like are diffused in a region where the bonding layer 27a is stacked, as will be described later. The metal element of the bonding layer 27a diffuses into the conductive coating layer 31, and thus the conductive coating layer 31 and the bonding layer 27a have high adhesive strength.

On the other hand, in the conductive coating layer 31, in a region where the bonding layer 27a is not stacked, there is almost no diffusion of the metal element of the bonding layer 27a.

When the connection portion 14 in the second embodiment is formed, steps (S1 to S5) of forming the photoelectric conversion element 12 are substantially similar to the steps of the manufacturing method in the first embodiment. However, in the second embodiment, the conductive coating layer 31 is formed on the back surface side of the conductive substrate 11 in step S1. In addition, in step S3, the group VI compound layer 32 is formed on a surface of the conductive coating layer 31.

Thereafter, a precursor layer (not illustrated) of the bonding layer 27a is formed on the conductive coating layer 31 including the group VI compound layer 32, and the interconnector 13 is disposed on the precursor layer of the bonding layer 27a. Then, the precursor layer of the bonding layer 27a and the interconnector 13 are welded together, thermal energy is applied, and the bonding layer 27a is formed.

When the bonding layer 27a is formed, the group VI element diffuses into the bonding layer 27a side, and the group VI compound layer 32 disappears. For this reason, in the concentration distribution of the group VI element in the thickness direction of the connection portion 14, there is no peak in the concentration of the group VI element in the interface between the conductive coating layer 31 and the bonding layer 27a.

In addition, the material of the bonding layer 27a contains a metal element to be easily chalcogenized, and thus the group VI element diffuses more into the bonding layer 27a side in the thickness direction of the connection portion 14. Therefore, in the concentration distribution of the group VI element in the thickness direction of the connection portion 14 in the second embodiment, a peak in the concentration of the group VI element is generated in the bonding layer 27a. In other words, the number of atoms of the group VI element contained in the bonding layer 27a is larger than the number of atoms of the group VI element contained in the conductive coating layer 31.

According to the configuration in the second embodiment described above, the adhesive strength between the conductive coating layer 31, which is formed on the substrate back surface side of the chalcogen solar cell, and the connection portion 14 can be improved.

### <Third Embodiment>

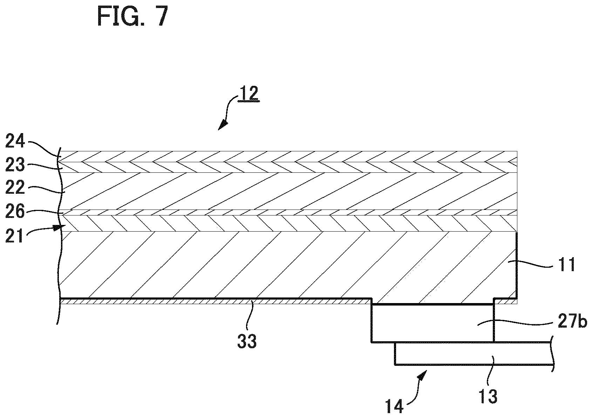

Fig. 7 is a cross-sectional view in a thickness direction illustrating a configuration example of a solar cell in a third embodiment. The third embodiment is a modified example from the second embodiment, and is different from the second embodiment in that the conductive coating layer 31 is not formed on the back surface side of the conductive substrate 11.

As illustrated in Fig. 7, a bonding layer 27b is stacked on the conductive substrate 11 in the third embodiment. Then, an end portion of the interconnector 13 is attached to the lower side in the drawing of the bonding layer 27b by welding. The interconnector 13 in the third embodiment is also a ribbon wire made of, for example, an electrically conductive metal containing Ag, Ti, an iron-nickel-cobalt alloy, or the like, as a material.

In addition, a group VI compound layer 33 made of Ti(Se,S)₂ is formed on a surface of the conductive substrate 11, except for a region where the bonding layer 27b is stacked. Ti(Se,S)₂ of the group VI compound layer 33 is formed on the surface of the conductive substrate 11, when the precursor layer 22p is chalcogenized to form the photoelectric conversion layer 22. Note that the group VI compound layer 33 made of Ti(Se,S)₂ is a substance having a graphite-like multilayer structure, and has a property of being easily peeled off by the cleavage between layers.

In other words, the group VI compound layer 33, which is easily peeled off, is not formed between the conductive substrate 11 and the bonding layer 27b. Therefore, the bonding layer 27b is hardly peeled off from the conductive substrate 11.

In addition, the bonding layer 27b in the third embodiment is a substance containing at least one of Al, Pt, Zn, and Sn and containing diffused Se and S. As the metal material of the bonding layer 27b, a metal material having a melting point equal to or higher than 230°C and higher than that of the solder alloy is used in order to ensure the use of the solar cell module 10 at high temperatures due to solar radiation or the like in outer space environments. Further, the material of the bonding layer 27b desirably contains a metal element having an alloy phase in a phase diagram with respect to the material of the conductive substrate 11 and the material of the interconnector 13 in order to promote diffusion of the metal element between the members.

In addition, the material of the bonding layer 27b desirably contains at least one of Al, Pt, Zn, and Sn, which are metal elements to be easily chalcogenized. Accordingly, the group VI compound is likely to be uniformly distributed in the bonding layer 27b. When the bonding layer 27b is formed, diffusion of the group VI element from the group VI compound layer 33 into the bonding layer 27b side is promoted, so that the group VI compound layer 33 can be made to disappear from between the conductive substrate 11 and the bonding layer 27b.

Further, in the conductive substrate 11, a metal element (for example, Al) of the bonding layer 27b, Se and S that are group VI elements, and the like are diffused in a region where the bonding layer 27b is stacked, as will be described later. The metal element of the bonding layer 27b diffuses into the conductive substrate 11, and thus the conductive substrate 11 and the bonding layer 27b have high adhesive strength.

On the other hand, in the conductive substrate 11, in a region where the bonding layer 27b is not stacked, there is almost no diffusion of the metal element of the bonding layer 27b.

When the connection portion 14 in the third embodiment is formed, steps (S1 to S5) of forming the photoelectric conversion element 12 are substantially similar to the steps of the manufacturing method in the first embodiment. Note that in the third embodiment, the group VI compound layer 33 is formed on a surface of the conductive substrate 11 in step S3.

Thereafter, a precursor layer (not illustrated) of the bonding layer 27b is formed on the conductive substrate 11 including the group VI compound layer 33, and the interconnector 13 is disposed on the precursor layer of the bonding layer 27b. Thereafter, the precursor layer of the bonding layer 27b and the interconnector 13 are welded together, thermal energy is applied, and the bonding layer 27b is formed.

When the bonding layer 27b is formed, the group VI element diffuses into the bonding layer 27b side, and the group VI compound layer 33 disappears. For this reason, in the concentration distribution of the group VI element in the thickness direction of the connection portion 14, there is no peak in the concentration of the group VI element in the interface between the conductive substrate 11 and the bonding layer 27b.

In addition, the material of the bonding layer 27b contains a metal element to be easily chalcogenized, and thus the group VI element diffuses more into the bonding layer 27b side in the thickness direction of the connection portion 14. Therefore, in the concentration distribution of the group VI element in the thickness direction of the connection portion 14 in the third embodiment, a peak of the concentration of the group VI element is generated in the bonding layer 27b. In other words, the number of atoms of the group VI element contained in the bonding layer 27b is larger than the number of atoms of the group VI element contained in the conductive substrate 11.

According to the configuration in the third embodiment described above, the adhesive strength between the conductive substrate 11 of the chalcogen solar cell and the connection portion 14 can be improved.

### <<Fourth Embodiment>>

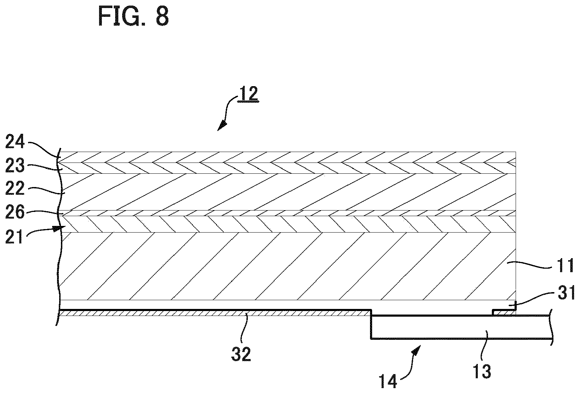

Fig. 8 is a cross-sectional view in a thickness direction illustrating a configuration example of a solar cell in a fourth embodiment. The fourth embodiment is a modified example from the second embodiment, and is different from the configuration in the second embodiment in that the interconnector 13 is directly welded with the conductive coating layer 31 without the bonding layer 27a being interposed. Note that also in the fourth embodiment, the group VI compound layer 32 made of Mo(Se,S)₂ is formed on a surface of the conductive coating layer 31, except for a region where the interconnector 13 is welded.

In other words, the group VI compound layer 32, which is easily peeled off, is not formed between the conductive coating layer 31 and the interconnector 13. Therefore, the interconnector 13 is hardly peeled off from the conductive coating layer 31.

In addition, a material having a melting point equal to or higher than 230°C and higher than that of a solder alloy is used as the material of the interconnector 13 to be applied in the connection portion 14 in order to ensure the use of the solar cell module 10 at high temperatures due to solar radiation or the like in outer space environments. In addition, the material of the interconnector 13 in the fourth embodiment contains a metal element having an alloy phase in a phase diagram with respect to the material of the conductive coating layer 31 in order to promote diffusion of the metal element between the members.

In the conductive coating layer 31 in the fourth embodiment, a metal element of the interconnector 13, Se and S that are group VI elements, and the like are diffused in a region where the interconnector 13 is bonded. The metal element of the interconnector 13 diffuses into the conductive coating layer 31, and thus the conductive coating layer 31 and the interconnector 13 have high adhesive strength.

On the other hand, in the conductive coating layer 31, in a region where the interconnector 13 is not bonded, there is almost no diffusion of the metal element of the interconnector 13.

When the connection portion 14 in the fourth embodiment is formed, steps (S1 to S5) of forming the photoelectric conversion element 12 are substantially similar to the steps of the manufacturing method in the first embodiment. However, in the fourth embodiment, the conductive coating layer 31 is formed on the back surface side of the conductive substrate 11 in step S1. In addition, in step S3, the group VI compound layer 32 is formed on a surface of the conductive coating layer 31.

Thereafter, the interconnector 13 is disposed on the conductive coating layer 31 including the group VI compound layer 32, the conductive coating layer 31 and the interconnector 13 are welded together, and thermal energy is applied. Accordingly, the group VI element diffuses from the interface between the conductive coating layer 31 and the interconnector 13, and the group VI compound layer 32 disappears. For this reason, in the concentration distribution of the group VI element in the thickness direction of the connection portion 14 in the fourth embodiment, there is no peak in the concentration of the group VI element in the interface between the conductive coating layer 31 and the interconnector 13.

According to the configuration in the fourth embodiment described above, the adhesive strength between the conductive coating layer 31, which is formed on the substrate back surface side of the chalcogen solar cell, and the interconnector 13 can be improved.

### <<Fifth Embodiment>>

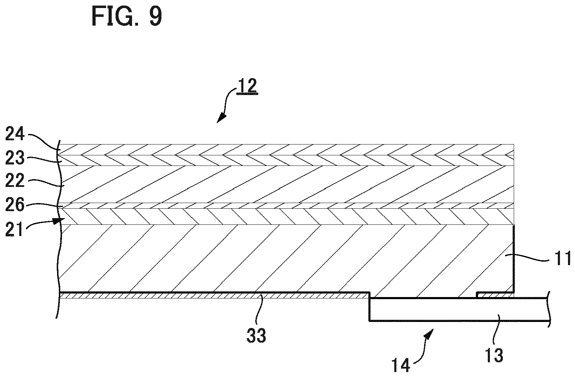

Fig. 9 is a cross-sectional view in a thickness direction illustrating a configuration example of a solar cell in a fifth embodiment. The fifth embodiment is a modified example from the third embodiment, and is different from the configuration in the third embodiment in that the interconnector 13 is directly welded with the conductive substrate 11 without the bonding layer 27b being interposed. Note that also in the fifth embodiment, the group VI compound layer 33 made of Ti(Se,S)₂ is formed on a surface of the conductive substrate 11, except for a region where the interconnector 13 is welded.

In other words, the group VI compound layer 33, which is easily peeled off, is not formed between the conductive substrate 11 and the interconnector 13. Therefore, the interconnector 13 is hardly peeled off from the conductive substrate 11.

In addition, a material having a melting point equal to or higher than 230°C and higher than that of a solder alloy is used as the material of the interconnector 13 to be applied in the connection portion 14 in order to ensure the use of the solar cell module 10 at high temperatures due to solar radiation or the like in outer space environments. Further, the material of the interconnector 13 in the fifth embodiment contains a metal element having an alloy phase in a phase diagram with respect to the material of the conductive substrate 11 in order to promote diffusion of the metal element between the members.

In the conductive substrate 11 in the fifth embodiment, a metal element of the interconnector 13, Se and S that are group VI elements, and the like are diffused in a region where the interconnector 13 is bonded. The metal element of the interconnector 13 diffuses into the conductive substrate 11, and thus the conductive substrate 11 and the interconnector 13 have high adhesive strength.

On the other hand, in the conductive substrate 11, in a region where the interconnector 13 is not bonded, there is almost no diffusion of the metal element of the interconnector 13.

When the connection portion 14 in the fifth embodiment is formed, steps (S1 to S5) of forming the photoelectric conversion element 12 are substantially similar to the steps of the manufacturing method in the first embodiment. Note that in the fifth embodiment, the group VI compound layer 33 is formed on a surface of the conductive substrate 11 in step S3.

Thereafter, the interconnector 13 is disposed on the conductive substrate 11 including the group VI compound layer 33, the conductive substrate 11 and the interconnector 13 are welded together, and thermal energy is applied. Accordingly, the group VI element diffuses from the interface between the conductive substrate 11 and the interconnector 13, and the group VI compound layer 33 disappears. For this reason, in the concentration distribution of the group VI element in the thickness direction of the connection portion 14 in the fifth embodiment, there is no peak in the concentration of the group VI element in the interface between the conductive substrate 11 and the interconnector 13.

According to the configuration in the fifth embodiment described above, the adhesive strength between the conductive substrate 11 of the chalcogen solar cell and the interconnector 13 can be improved.

### <<Examples>>

Hereinafter, examples of the solar cell module in the present invention will be described.

Here, a connection portion in an example is formed in a similar manner to the configuration described in the first embodiment. That is, Ti is a material of the substrate, and the backside electrode layer before the welding is a Mo film in which a Se layer is formed on a surface. The bonding layer is formed by applying thermal energy of welding to a precursor in which an Al layer and an Ag layer are stacked. The backside electrode layer after the welding is Mo in which Al and Se are diffused, and the bonding layer after the welding is a substance containing Se diffused into Ag and Al.

### (Concentration Distribution of Elements in Connection Portion)

In an example, the concentration distribution of elements in the connection portion of the solar cell module was obtained in the following method.

First, a cross-section in the thickness direction of the connection portion in an example is formed by use of a focused ion beam (FIB) device. Then, a scanning ion microscope (SIM) image of the cross-section of the connection portion was captured at an accelerating voltage of 15 kV. Thereafter, elements contained in the cross-section of the connection portion were analyzed by energy dispersive X-ray analysis (EDX).

Note that the instruments that were used in the analysis of elements in an example are listed as follows. The FIB device is SMI3200F manufactured by SII NanoTechnology Inc., the SEM is SU8240 manufactured by Hitachi High-Technologies Corporation, and the EDX is EX-370 manufactured by HORIBA, Ltd.

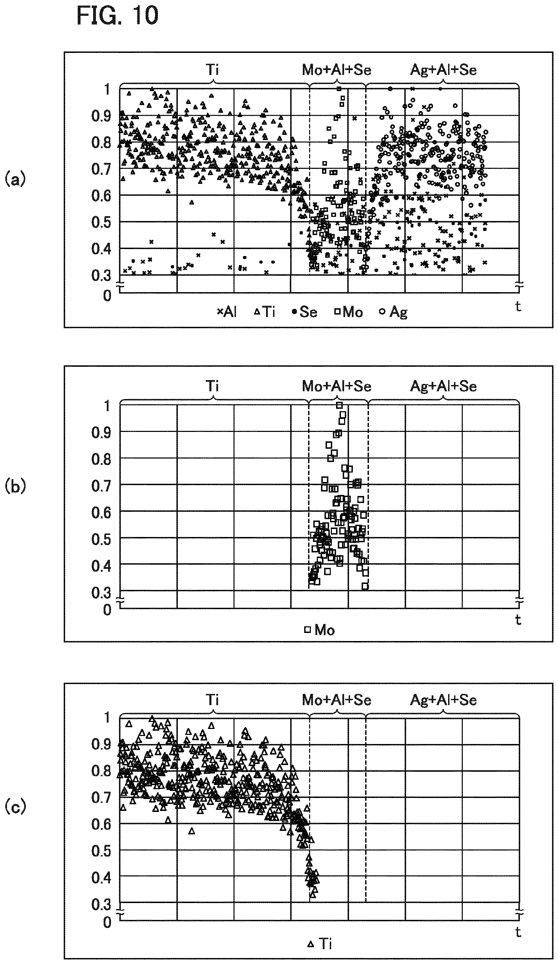

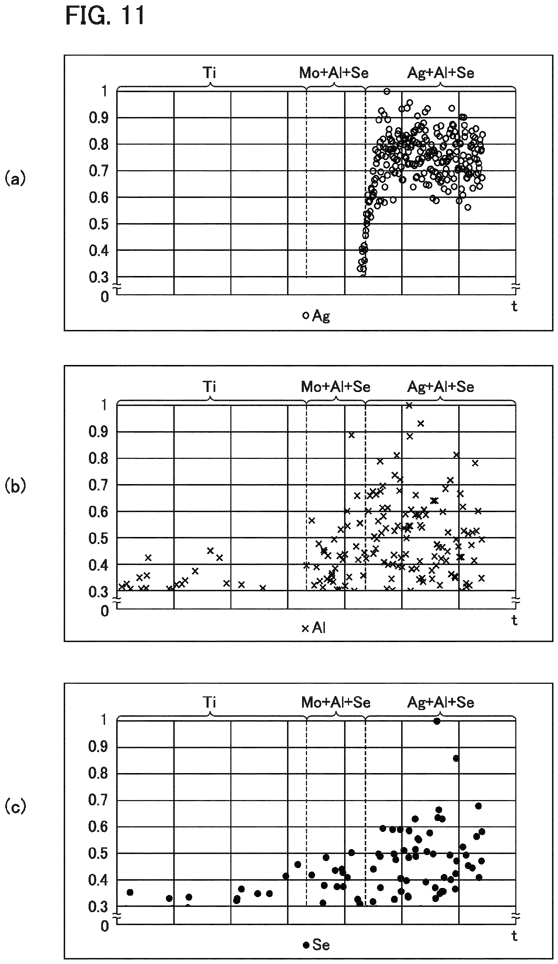

Figs. 10 and 11 are diagrams illustrating concentration distributions of the respective elements in a thickness direction of a connection portion in an example.

In each of Figs. 10 and 11, the vertical axis represents the content of an element, and the horizontal axis represents the position of the connection portion in the thickness direction t. In the horizontal axes of Figs. 10 and 11, the left end corresponds to the back surface side of the light-receiving surface, and the right end corresponds to the light-receiving surface side.

In addition, the contents indicated on the vertical axes in Figs. 10 and 11 are normalized for every element with the maximum value of the content as 1. Note that each point indicated in Figs. 10 and 11 is plotted, when a normalized content equal to or higher than 30% as a threshold value is detected.

Fig. 10(a) illustrates a concentration distribution example of Mo, Ti, Ag, Al, and Se of the connection portion in an overlapping manner. Fig. 10(b) illustrates a concentration distribution example of Mo in the connection portion, and Fig. 10(c) illustrates a concentration distribution example of Ti in the connection portion.

In addition, Fig. 11(a) illustrates a concentration distribution example of Ag in the connection portion, Fig. 11(b) illustrates a concentration distribution example of Al in the connection portion, and Fig. 11(c) illustrates a concentration distribution example of Se in the connection portion.

As illustrated in Figs. 10 and 11, the backside electrode layer of the connection portion contains Mo, Al, and Se (in the drawing, indicated by Mo+Al+Se), and the bonding layer contains Ag, Al, and Se (in the drawing, indicated by Ag+Al+Se). From Figs. 10(a), 11(b), and 11(c), it can be understood that Al and Se are diffused over the backside electrode layer and the bonding layer.

In addition, as illustrated in Fig. 11(c), Se is widely distributed over the backside electrode layer and the bonding layer, and there is no peak in the concentration distribution of Se in the boundary between the backside electrode layer and the bonding layer. Therefore, it can be understood that the group VI compound layer is not present in the boundary between the backside electrode layer and the bonding layer in the connection portion.

Further, as illustrated in Fig. 11(c), Se is detected more in the bonding layer than in the backside electrode layer. Therefore, it can be understood that the number of atoms of Se contained in the bonding layer is larger than the number of atoms of Se contained in the backside electrode layer.

Further, as illustrated in Fig. 11(c), in comparing the maximum value of Se in the backside electrode layer with the maximum value of Se in the bonding layer, the maximum value of Se in the bonding layer is larger. Therefore, it can be understood that the peak of the concentration of Se is present in a part of the bonding layer.

### (Adhesive Strength Test of Connection Portion)

In addition, in order to evaluate the adhesive strength of the connection portion of the solar cell module, the following test was conducted. In the test, a tip end of an interconnector after the welding was clamped by a jig, and the tip end of the interconnector was pulled upward in 45-degree direction at a speed of 5 mm/min by use of an autograph device. Then, the tensile strength (maximum strength) at the time when the interconnector is detached from the connection portion is measured.

As test targets, a test piece of the above example (hereinafter, referred to as Example 1) and the following three test pieces as Comparative Examples were used.

Comparative Example 1 denotes a test piece in which an interconnector is welded with a layered body of Ti substrate/Mo(MoSeS)/Ag. Comparative Example 2 denotes a test piece in which an interconnector is welded with a layered body of Ti substrate/Mo(MoSeS)/In-solder. Note that a bonding area of Comparative Example 2 is approximately 60 times that of Example. Comparative Example 3 denotes a test piece in which an interconnector is welded with a layered body of Ti substrate/Mo(MoSeS). Note that the materials of the interconnectors of Example 1 and Comparative Examples 1 to 3 are all Ag.

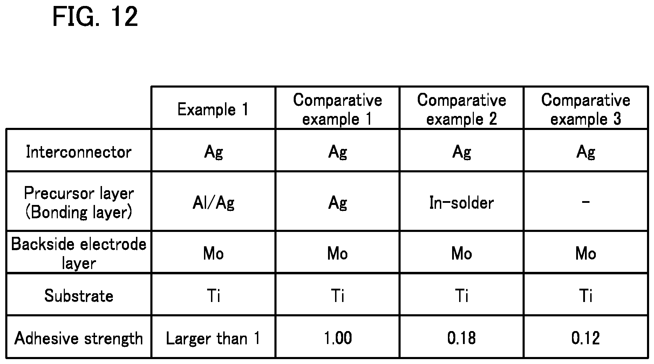

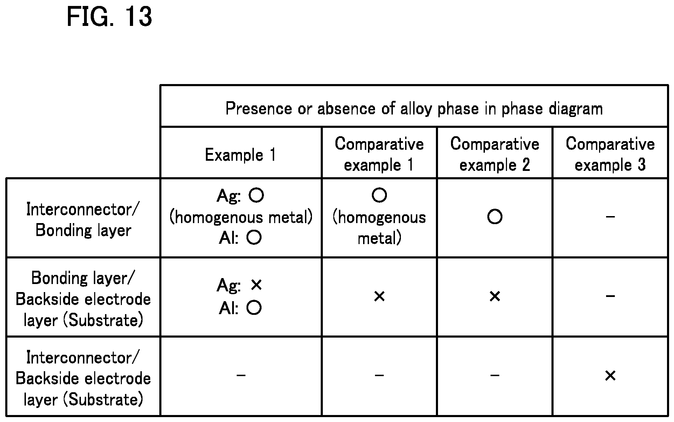

Fig. 12 is a table indicating results of adhesive strength tests of the Example 1 and Comparative Examples 1 to 3, and Fig. 13 is a table indicating presence or absence of an alloy phase in a phase diagram of the Example 1 and Comparative Examples 1 to 3. In the table of Fig. 13, "o" indicates a case where the alloy phase is present in the phase diagram between the members that face each other, and "×" indicates a case where the alloy phase is not present in the phase diagram between the members that face each other. In addition, in Figs. 12 and 13, "-" indicates a case where there is no corresponding configuration.

In Fig. 12, values of the maximum strength that has been normalized with Comparative Example 1 as a reference are respectively indicated.

Assuming that the maximum strength of the test piece of Comparative Example 1 was 1, the maximum strength of the test piece of Comparative Example 2 was 0.18, and the maximum strength of the test piece of Comparative Example 3 was 0.12. On the other hand, it was confirmed that the test piece of Example 1 was larger than 1, had the maximum strength higher than any of Comparative Examples 1 to 3, and had good adhesive strength of the connection portion.

In addition, as illustrated in Fig. 13, in the test piece of Example 1, the interconnector and the bonding layer both contain Ag (homogeneous metal) as a material, and Ag that is a material of the interconnector and Al contained in a material of the bonding layer have an alloy phase in a phase diagram. Further, in the test piece of Example 1, Al contained in a material of the bonding layer and Mo that is a material of the backside electrode layer have an alloy phase in a phase diagram. Therefore, in the test piece of Example 1, diffusion occurs between the homogeneous metals or the metals having the alloy phase in the phase diagram at the time of welding, and it is considered that the adhesive strength between the respective elements is improved.

On the other hand, in the test piece of Comparative Example 1, neither Ag that is a material of the bonding layer nor Mo that is a material of the backside electrode layer has an alloy phase in a phase diagram. In addition, in the test piece of Comparative Example 2, neither In-solder that is a material of the bonding layer nor Mo that is a material of the backside electrode layer has an alloy phase in a phase diagram. Therefore, in Comparative Examples 1 and 2, no diffusion of metal elements occurs in the materials of the bonding layer and the backside electrode layer. Therefore, it is considered that the adhesive strength is lower than that of Example 1.

Similarly, in the test piece of Comparative Example 3, neither Ag that is a material of the interconnector nor Mo that is a material of the backside electrode layer has an alloy phase in a phase diagram. Therefore, in Comparative Example 3, no diffusion of metal elements occurs in the materials of the interconnector and the backside electrode layer. Therefore, it is considered that the adhesive strength is lower than that of Example 1.

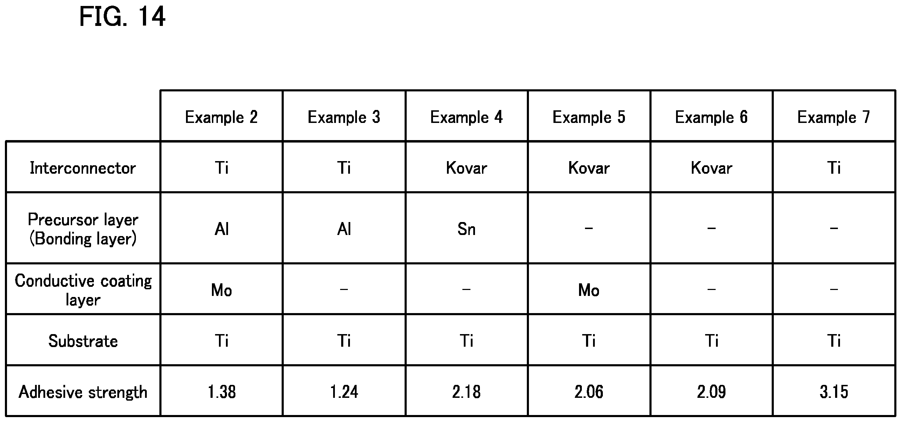

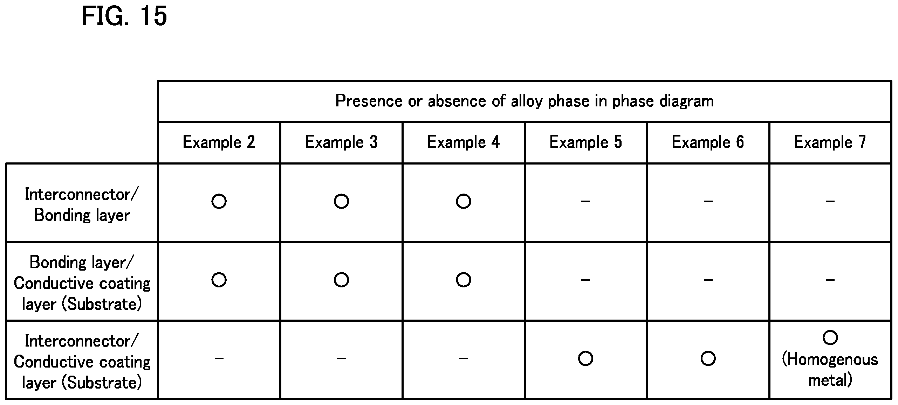

Fig. 14 is a table indicating results of adhesive strength tests of Examples 2 to 7, and Fig. 15 is a table indicating presence or absence of an alloy phase in a phase diagram of Examples 2 to 7. The way of reading the tables in Figs. 14 and 15 are similar to that of Figs. 12 and 13.

A test piece of Example 2 has a configuration corresponding to the second embodiment described above. In Example 2, Ti is a material of the interconnector, Al is a material of the bonding layer, Mo is a material of the conductive coating layer, and Ti is a material of the substrate. In Example 2, the materials of the interconnector and the bonding layer have an alloy phase in a phase diagram, and the materials of the bonding layer and the conductive coating layer have an alloy phase in a phase diagram. Assuming that the maximum strength of the test piece of Comparative Example 1 was 1, the maximum strength of the test piece of Example 2 was 1.38, which indicated a larger value than that of Comparative Example 1.

The test piece of Example 3 has a configuration corresponding to the third embodiment described above. In Example 3, Ti is a material of the interconnector, Al is a material of the bonding layer, and Ti is a material of the substrate. In Example 3, the materials of the interconnector and the bonding layer have an alloy phase in a phase diagram, and the materials of the bonding layer and the substrate have an alloy phase in a phase diagram. Assuming that the maximum strength of the test piece of Comparative Example 1 was 1, the maximum strength of the test piece of Example 3 was 1.24, which indicated a larger value than that of Comparative Example 1.

The test piece of Example 4 has a configuration corresponding to the third embodiment described above. In Example 4, Kovar is a material of the interconnector, Sn is a material of the bonding layer, and Ti is a material of the substrate. In Example 4, the materials of the interconnector and the bonding layer have an alloy phase in a phase diagram, and the materials of the bonding layer and the substrate have an alloy phase in a phase diagram. Assuming that the maximum strength of the test piece of Comparative Example 1 was 1, the maximum strength of the test piece of Example 4 was 2.18, which indicated a larger value than that of Comparative Example 1.

The test piece of Example 5 has a configuration corresponding to the fourth embodiment described above. In Example 5, Kovar is a material of the interconnector, Mo is a material of the conductive coating layer, and Ti is a material of the substrate. In Example 5, the materials of the interconnector and the conductive film layer have an alloy phase in a phase diagram. Assuming that the maximum strength of the test piece of Comparative Example 1 was 1, the maximum strength of the test piece of Example 5 was 2.06, which indicated a larger value than that of Comparative Example 1.

The test piece of Example 6 has a configuration corresponding to the fifth embodiment described above. In Example 6, Kovar is a material of the interconnector, and Ti is a material of the substrate. In Example 6, the materials of the interconnector and the substrate have an alloy phase in a phase diagram. Assuming that the maximum strength of the test piece of Comparative Example 1 was 1, the maximum strength of the test piece of Example 6 was 2.09, which indicated a larger value than that of Comparative Example 1.

The test piece of Example 7 has a configuration corresponding to the fifth embodiment described above. In Example 7, Ti is a material of the interconnector, and Ti is a material of the substrate. In Example 6, the materials of the interconnector and the substrate are homogeneous metals. Assuming that the maximum strength of the test piece of Comparative Example 1 was 1, the maximum strength of the test piece of Example 7 was 3.15, which indicated a larger value than that of Comparative Example 1.

As described above, in Examples 2 to 7, unlike Comparative Examples 1 to 3 described above, all metal materials between the elements that face each other have an alloy phase in a phase diagram. Therefore, the metal elements diffuse between the elements that face each other at the time of welding, and it is considered that the adhesive strength between the elements is improved.

In particular, the test piece of Example 7 has high affinity, because the materials of the interconnector and the substrate are homogeneous metals. The metal elements diffuse in the interface between the interconnector and the substrate at the time of welding, and it is considered that the adhesive strength between the interconnector and the substrate is further improved.

### <<Supplementary Matters of Embodiments>>

In the above embodiments, the configuration of the solar cell module having a single cell structure including one photoelectric conversion element has been described. However, the solar cell module may have an integrated structure in which a plurality of photoelectric conversion elements are arranged in a planar direction of the light-receiving surface of the conductive substrate and these photoelectric conversion elements are connected in series. Note that in the case of the solar cell module having the integrated structure, an insulating layer is formed between the conductive substrate and the first electrode layer.

In addition, the precursor layer 27p of the bonding layer 27 is not limited to the configurations in the above embodiments, in which one Al layer 27p1 and one Ag layer 27p2 are stacked. For example, the precursor layer 27p may be made up of a single-layer film containing Al and Ag. Further, the precursor layer 27p may be made up of a stacked film of three or more layers. In a case where the precursor layer 27p is the stacked film of three or more layers, layers of the two materials may be alternately arranged in a thickness direction, and a layer of another material may be further added to the layers of the two materials. In addition, a layer containing Al and Ag may be added to the stacked film.

In addition, in the fourth embodiment described above (Fig. 8), the configuration example in which the interconnector 13 is bonded with the conductive coating layer 31, which is formed on the back surface side of the conductive substrate 11, has been described. However, the present invention is also applicable to a configuration in which the interconnector 13 is bonded with the first electrode layer 21 (backside electrode) including the group VI compound layer 26, on the light-receiving surface side of the conductive substrate 11.

Similarly, in the fifth embodiment described above (Fig. 9), the configuration example in which the interconnector 13 is bonded with the back surface side of the conductive substrate 11 has been described. However, the present invention is also applicable to a configuration in which the interconnector 13 is bonded with the conductive substrate 11, on a surface of which the group VI compound layer 33 is formed, on the light-receiving surface side of the conductive substrate 11.

Further, the electrode structure of the solar cell in the present invention is not limited to outer space applications. For example, the present invention may be applied to a solar cell to be installed on the ground, in forming a connection portion that is less likely to have a failure even when receiving external force of strong winds or an earthquake.

As described heretofore, the embodiments of the present invention have been described. However, the embodiments are each presented as an example, and there is no intention of limiting the scope of the present invention. The embodiments can be implemented in various forms other than the above description, and various omissions, substitutions, changes, and the like can be made without departing from the gist of the present invention. Embodiments and modifications thereof are included in the scope and gist of the present invention, and the invention described in the claims and equivalents thereof are also included in the scope and gist of the present invention.

In addition, the present application claims priority based on Japanese Patent Application No. 2020-211733 filed on December 21, 2020, and the entire contents of Japanese Patent Application No. 2020-211733 are incorporated herein by reference.

### Reference Signs List

10 Solar cell module
10a Wiring region
11 Conductive substrate
12 Photoelectric conversion element
13 Interconnector
14 Connection portion
21, 21a First electrode layer
22 Photoelectric conversion layer
22p Precursor layer
26, 32, 33 Group VI compound layer
27, 27a, 27b Bonding layer
27p Precursor layer
27p1 Al layer
27p2 Ag layer
31 Conductive coating layer

## Claims

1. An electrode structure of a solar cell, the electrode structure comprising an electric conductor on a substrate side of a chalcogen solar cell, and a wiring element to be electrically connected with the electric conductor, wherein
the wiring element is stacked on and bonded with the electric conductor,
the wiring element and the electric conductor each contain a group VI element, and
a peak of a concentration distribution of the group VI element is shifted from an interface between the electric conductor and the wiring element in a stacked direction of the electric conductor and the wiring element.

2. The electrode structure of the solar cell according to claim 1, wherein
the electric conductor is exposed in a position that does not overlap a photoelectric conversion layer of the chalcogen solar cell on a light-receiving surface side of the chalcogen solar cell, and
the wiring element is stacked on the electric conductor exposed on the light-receiving surface side.

3. The electrode structure of the solar cell according to claim 2, wherein
the electric conductor is a backside electrode layer formed on a substrate of the chalcogen solar cell,
the wiring element includes a wiring member and a bonding layer disposed between the backside electrode layer and the wiring member, and
the peak of the concentration distribution of the group VI element is shifted from an interface between the backside electrode layer and the bonding layer in a stacked direction of the backside electrode layer and the bonding layer.

4. The electrode structure of the solar cell according to claim 3, wherein
a material of the backside electrode layer and a material of the bonding layer have an alloy phase in a phase diagram, and
a material of the bonding layer and a material of the wiring member have an alloy phase in a phase diagram.

5. The electrode structure of the solar cell according to claim 3 or 4, wherein
a melting point of the bonding layer is equal to or higher than 230°C.

6. The electrode structure of the solar cell according to one of claims 3 to 5, wherein
the peak of the concentration distribution of the group VI element is present in the bonding layer in the stacked direction of the backside electrode layer and the bonding layer.

7. The electrode structure of the solar cell according to one of claims 3 to 6, wherein
the number of atoms of the group VI element contained in the bonding layer is larger than the number of atoms of the group VI element contained in the backside electrode layer in a region corresponding to the bonding layer.

8. The electrode structure of the solar cell according to one of claims 3 to 7, wherein
the bonding layer contains at least one of Al, Pt, Zn, and Sn.

9. The electrode structure of the solar cell according to one of claims 3 to 8, wherein
the backside electrode layer in a region corresponding to the bonding layer contains a part of a metal element of the bonding layer.

10. The electrode structure of the solar cell according to one of claims 3 to 9, wherein
the wiring member contains a part of a metal element of the bonding layer.

11. The electrode structure of the solar cell according to claim 10, wherein
the wiring member contains Ag, and
the bonding layer contains Al and Ag.

12. The electrode structure of the solar cell according to one of claims 3 to 10, wherein
a material of the wiring member contains either Ti or an iron-nickel-cobalt alloy.

13. The electrode structure of the solar cell according to claim 1, wherein
the electric conductor is exposed on a surface on an opposite side to a light-receiving surface of the chalcogen solar cell, and
the wiring element is stacked on the electric conductor exposed on the surface on the opposite side.

14. The electrode structure of the solar cell according to claim 13, wherein
the electric conductor is either a conductive layer formed on a substrate of the chalcogen solar cell or a conductive substrate of the chalcogen solar cell,
the wiring element includes a wiring member and a bonding layer disposed between the backside electrode layer and the wiring member, and
the peak of the concentration distribution of the group VI element is shifted from an interface between the electric conductor and the bonding layer in a stacked direction of the electric conductor and the bonding layer.

15. The electrode structure of the solar cell according to claim 14, wherein
a material of the electric conductor and a material of the bonding layer have an alloy phase in a phase diagram, and
the material of the bonding layer and a material of the wiring member have an alloy phase in a phase diagram.

16. The electrode structure of the solar cell according to claim 13, wherein
the electric conductor is either a conductive layer formed on a substrate of the chalcogen solar cell or a conductive substrate of the chalcogen solar cell,
the wiring element is a wiring member stacked on the electric conductor, and
the peak of the concentration distribution of the group VI element is shifted from an interface between the electric conductor and the wiring member in a stacked direction of the electric conductor and the wiring member.

17. The electrode structure of the solar cell according to claim 16, wherein
a material of the electric conductor and a material of the wiring member have an alloy phase in a phase diagram.

18. The electrode structure of the solar cell according to one of claims 14 to 17, wherein
a material of the wiring member contains either Ti or an iron-nickel-cobalt alloy.

19. A manufacturing method of an electrode structure of a solar cell, the electrode structure including an electric conductor on a substrate side of a chalcogen solar cell, and a wiring element to be electrically connected with the electric conductor, the manufacturing method comprising:
disposing either the wiring element or a precursor layer of the wiring element on the electric conductor containing a compound of a group VI element on a surface of the electric conductor; and
applying thermal energy generated by welding to either the wiring element or the precursor layer of the wiring element to bond the wiring element with the electric conductor, wherein
a peak of a concentration distribution of the group VI element is shifted from an interface between the electric conductor and the wiring element that have been bonded together in a stacked direction of the electric conductor and the wiring element.

20. The manufacturing method of the electrode structure of the solar cell according to claim 19, wherein
the electric conductor is exposed in a position that does not overlap a photoelectric conversion layer of the chalcogen solar cell on a light-receiving surface side of the chalcogen solar cell, and
the wiring element is stacked on the electric conductor exposed to the light-receiving surface side.

21. The manufacturing method of the electrode structure of the solar cell according to claim 20, wherein
the electric conductor is a backside electrode layer formed on a substrate of the chalcogen solar cell, and
the wiring element includes a wiring member and a bonding layer disposed between the backside electrode layer and the wiring member.

22. The manufacturing method of the electrode structure of the solar cell according to claim 21, wherein
forming a precursor layer containing either at least one of constituent elements of the backside electrode layer or one of Al, Pt, Zn, and Sn, on the backside electrode layer containing the compound of the group VI element on a surface of the backside electrode layer;
disposing the wiring member on the precursor layer; and
welding the precursor layer and the wiring member to apply the thermal energy to the precursor layer, to form the bonding layer containing an element contained in the precursor layer and the group VI element, and to bond the backside electrode layer and the wiring member.

23. The manufacturing method of the electrode structure of the solar cell according to claim 22, wherein
the group VI element contained in the bonding layer diffuses from the compound present on the surface of the backside electrode layer before the welding.

24. The manufacturing method of the electrode structure of the solar cell according to claim 22 or 23, wherein
the precursor layer contains at least one of constituent elements of the wiring member.

25. The manufacturing method of the electrode structure of the solar cell according to claim 24, wherein
the wiring member contains Ag, and
the precursor layer contains Al and Ag.

26. The manufacturing method of the electrode structure of the solar cell according to claim 24 or 25, wherein
the precursor layer has a structure in which a first layer containing one of Al, Pt, Zn, and Sn and a second layer containing at least one of constituent elements of the wiring member are stacked, and
the second layer is disposed on a surface of the precursor layer that faces the wiring member.

27. The manufacturing method of the electrode structure of the solar cell according to claim 26, wherein
the first layer contains Al, and
the second layer contains Ag.

28. The manufacturing method of the electrode structure of the solar cell according to claim 19, wherein
the electric conductor is exposed on a surface on an opposite side to a light-receiving surface of the chalcogen solar cell, and
the wiring element is stacked on the electric conductor exposed on the surface on the opposite side.

29. The manufacturing method of the electrode structure of the solar cell according to claim 28, wherein
the electric conductor is either a conductive layer formed on a substrate of the chalcogen solar cell or a conductive substrate of the chalcogen solar cell, and
the wiring element includes a wiring member and a bonding layer disposed between the backside electrode layer and the wiring member.

30. The manufacturing method of the electrode structure of the solar cell according to claim 29, wherein
a material of the electric conductor and a material of the bonding layer have an alloy phase in a phase diagram, and
the material of the bonding layer and a material of the wiring member have an alloy phase in a phase diagram.

31. The manufacturing method of the electrode structure of the solar cell according to claim 28, wherein
the electric conductor is either a conductive layer formed on a substrate of the chalcogen solar cell or a conductive substrate of the chalcogen solar cell, and
the wiring element is a wiring member stacked on the electric conductor.

32. The manufacturing method of the electrode structure of the solar cell according to claim 31, wherein
a material of the electric conductor and a material of the wiring member have an alloy phase in a phase diagram.

33. The manufacturing method of the electrode structure of the solar cell according to one of claims 29 to 32, wherein
a material of the wiring member contains either Ti or an iron-nickel-cobalt alloy.
